# EUROPEAN PATENT APPLICATION

(11) **EP 2 541 612 A1**
(43) Date of publication of application: **02.01.2013**
(21) Application number: 10846613.7
(22) Date of filing: 11.11.2010
(51) Int. Cl.: H01L 31/04

(54) **THIN-FILM PHOTOELECTRIC CONVERSION DEVICE**

(30) Priority: 25.02.2010 JP 2010041074
(71) Applicant: Mitsubishi Heavy Industries, Ltd., Tokyo 108-8215 (JP); National Institute of Advanced Industrial Science and Technology, Tokyo 100-8921 (JP)
(72) Inventor: MIZUNO, Koichi, Tokyo 108-8215 (JP); TAKEUCHI, Yoshiaki, Tokyo 108-8215 (JP); SAKAI, Satoshi, Tokyo 108-8215 (JP); TSURUGA, Shigenori, Tokyo 108-8215 (JP); MATSUI, Takuya, Tsukuba-shi Ibaraki 305-8568 (JP); KONDO, Michio, Tsukuba-shi Ibaraki 305-8568 (JP); JIA, Haijun, Tsukuba-shi Ibaraki 305-8568 (JP)
(74) Representative: Henkel, Breuer & Partner
(86) International application number: PCT/JP2010/070125
(87) International publication number: WO 2011/104950

(57) **Abstract**

Provided is a highly-efficient triple-junction thin-film photoelectric conversion device in which the short-circuit current value obtained at each photoelectric conversion layer is equalized, and which has a high haze factor. A thin-film photoelectric conversion device (100) is provided with a transparent electrode layer (2) and three silicon photoelectric conversion layers (91, 92, 93), in said order, on a substrate (1). The transparent electrode layer (2) has at least one opening section (5), which exposes the surface of the substrate (1) and which was formed by means of the etching process, and a haze factor of 60% or more in relation to the light in the broad wavelength region of the transparent electrode layer (2).

## Description

### {Technical Field}

The present invention relates to a thin-film photovoltaic device, and relates particularly to a thin-film solar cell in which an electric power generation film is formed by deposition.

### {Background Art}

One known example of a photovoltaic device that receives light and converts the light into electric power is a thin-film solar cell comprising an electric power generation layer (a photovoltaic layer) formed by stacking thin films of silicon-based layers. A thin-film solar cell is generally produced by sequentially stacking a transparent electrode layer, a silicon-based semiconductor layer (photovoltaic layer) and a back electrode layer on top of a substrate. The photovoltaic layer has a pin junction formed using p-type, i-type, and n-type semiconductor materials, and this pin junction functions as the energy conversion unit, converting the light energy from sunlight into electrical energy. Known photovoltaic devices include single-junction devices having a single photovoltaic layer, and double-junction or triple-junction devices that employ a plurality of stacked photovoltaic layers. In a triple-junction photovoltaic device, the photovoltaic layers are termed, from the substrate-side of the device, the top cell, the middle cell and the bottom cell.

The transparent electrode layer is composed of a transparent conductive film comprising a metal oxide such as zinc oxide (ZnO), tin oxide (SnO₂) or indium tin oxide (ITO) as the main component. Investigations are continuing into increasing the photovoltaic conversion efficiency of thin-film solar cells by increasing the light transmittance, increasing the haze ratio, and lowering the sheet resistance of the substrate having the transparent electrode layer provided thereon.

PTL 1 discloses a photovoltaic device substrate comprising a transparent conductive layer having at least one opening through which the substrate is exposed. The photovoltaic device of PTL 1 is either a single-junction or a double-junction device, in which the light transmittance is increased by providing an opening in the transparent conductive layer formed on the substrate, and the sheet resistance of the overall transparent conductive layer is reduced by covering the opening with a separate thin transparent conductive layer. Further, the haze ratio is increased by forming asperity on the surface of the transparent conductive layer.

Further, because light reflection loss occurs at the interface between the transparent electrode layer and the photovoltaic layer, PTL 2 discloses a solar cell comprising an antireflection layer on the transparent conductive layer.

### {Citation List}

### {Patent Literature}

{PTL 1} PCT International Publication No. WO 2005/081324 (paragraphs [0038] to [0043])
{PTL 2} Japanese Unexamined Patent Application, Publication No. 2005-244073 (claim 1)

### {Summary of Invention}

### {Technical Problem}

In a triple-junction photovoltaic device, the short-circuit current is limited by the smallest value among the photocurrents generated by each of the photovoltaic layers. Accordingly, it is necessary to increase the sum of the photocurrents generated by each of the photovoltaic layers, and increase the open-circuit voltage.

Furthermore, a triple-junction (a-Si/µc-Si/µc-SiGe) photovoltaic device is able to better utilize light form the long wavelength region than a double-junction (a-Si/µc-Si) photovoltaic device. As a result, in the long wavelength region of 800 nm to 1,400 nm, a substrate having a high haze ratio (capable of coping with optical path lengths of light from the long wavelength region) is required. Furthermore, in a triple-junction photovoltaic device, the light utilization efficiency must be improved across a broad range of light wavelengths from short wavelengths to long wavelengths. In a triple-junction photovoltaic device, deterioration in the short-circuit current due to the current-limiting bottom cell is problematic, and more effective utilization of light in the bottom cell is keenly sought.

The present invention has been developed in light of the circumstances described above, and has an object of providing a high-efficiency photovoltaic device in which the haze ratio is high across a broad range of light wavelengths used in thin-film silicon-based solar cells, and in which the short-circuit current values obtained from each of the photovoltaic layers are equalized.

### {Solution to Problem}

In order to achieve the above object, the present invention provides a thin-film photovoltaic device comprising a transparent electrode layer and three photovoltaic layers stacked in sequence on a substrate, wherein the transparent electrode layer has at least one opening formed by an etching treatment that exposes the surface of the substrate, and the haze ratio of the transparent electrode layer relative to light of a broad wavelength region is at least 60%.

In a triple-junction photovoltaic device, light from a broad wavelength region can be utilized. It is known that a thin-film, silicon-based triple-junction photovoltaic device is able to utilize light across a wavelength region from 400 nm to 1,200 nm. According to the present invention, by etching the transparent electrode layer, a high haze ratio can be obtained for a broad wavelength region that includes not only the short wavelength region, but also the long wavelength region.
Further, because the transparent electrode layer has crater-like through-holes (openings) that reach to the substrate, flat sections are formed that are able to increase the open-circuit voltage.
It is preferable that the haze ratio is at least 60% across a broad wavelength region (namely wavelengths from 400 nm to 1,200 nm). In particular, the haze ratio of the transparent electrode layer relative to light having wavelengths of 800 nm to 1100 nm is preferably 65% or greater. This ensures that the sum of the short-circuit current values obtained for each of the photovoltaic layers can be increased, enabling an increase in the equalized short-circuit current value.
Furthermore, the opening ratio within the transparent electrode layer is preferably not less than 15% and not more than 25%.

The sheet resistance of the transparent electrode layer is preferably within a range from not less than 30 Ω/square to not more than 40 Ω/square, and is more preferably within a range from not less than 30 Ω/square to not more than 35 Ω/square. This ensures that a transparent electrode layer can be achieved that yields a high haze ratio even for the long wavelength region.

In the structure described above, by ensuring that the transparent electrode layer, in which at least one opening has been formed by an etching treatment, has a thickness that is not less than a certain value, the size of the asperity on the transparent electrode layer surface can be increased, enabling the haze ratio to be increased. As a result of intensive investigation, the inventors of the present invention discovered that a structure in which the thickness of the transparent electrode layer is not less than 0.9 µm is preferable.

In the structure described above, an antireflection layer that exhibits conductivity is preferably formed on the transparent electrode layer. By adopting such a structure, light reflection loss at the interface between the transparent electrode layer and the photovoltaic layer can be reduced. In other words, a photovoltaic device can be obtained that is capable of preventing not only electrical loss, but also optical loss.

### {Advantageous Effects of Invention}

According to the present invention, by forming a transparent electrode layer having a high haze ratio across a broad wavelength region (namely, wavelengths from 400 nm to 1,200 nm), the sum of the photocurrents generated in each of the photovoltaic layers of a triple-junction photovoltaic device can be increased. Further, by including openings in the transparent electrode layer, the open-circuit voltage can also be increased. In other words, a photovoltaic device having a high photovoltaic conversion efficiency can be obtained.

### {Brief Description of Drawings}

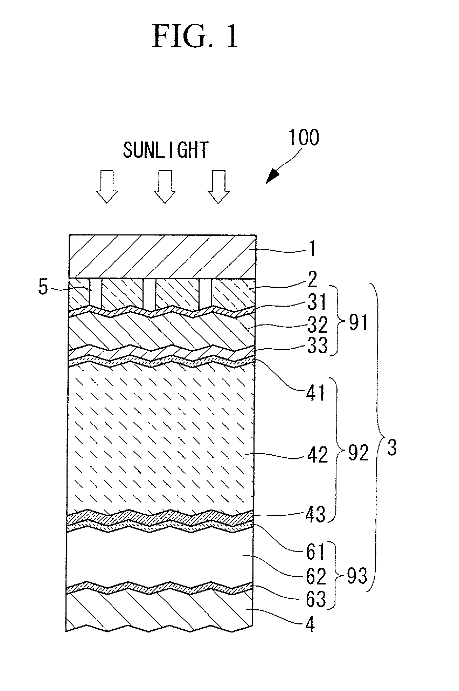

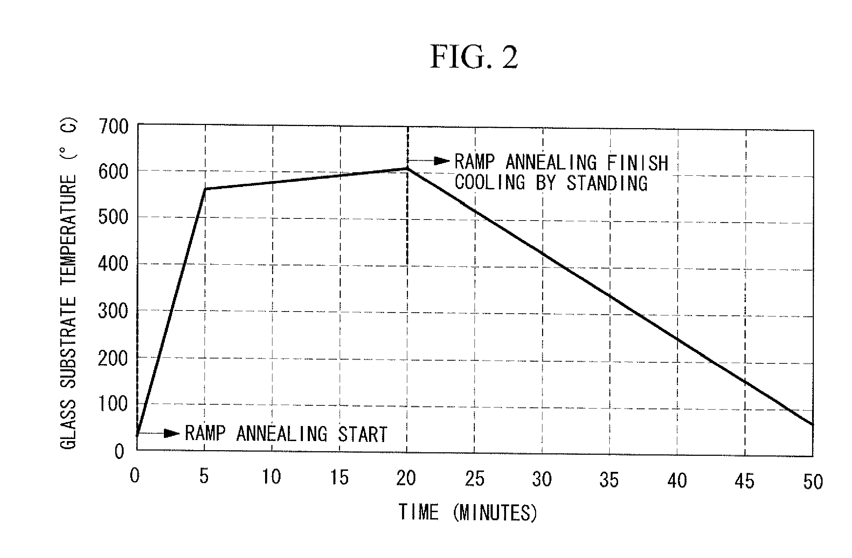

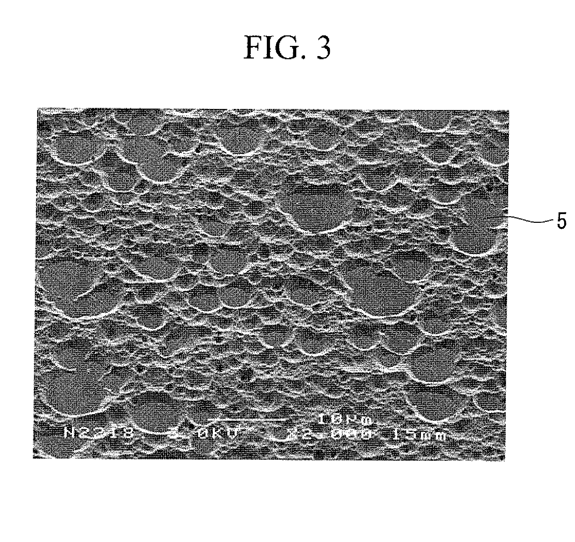

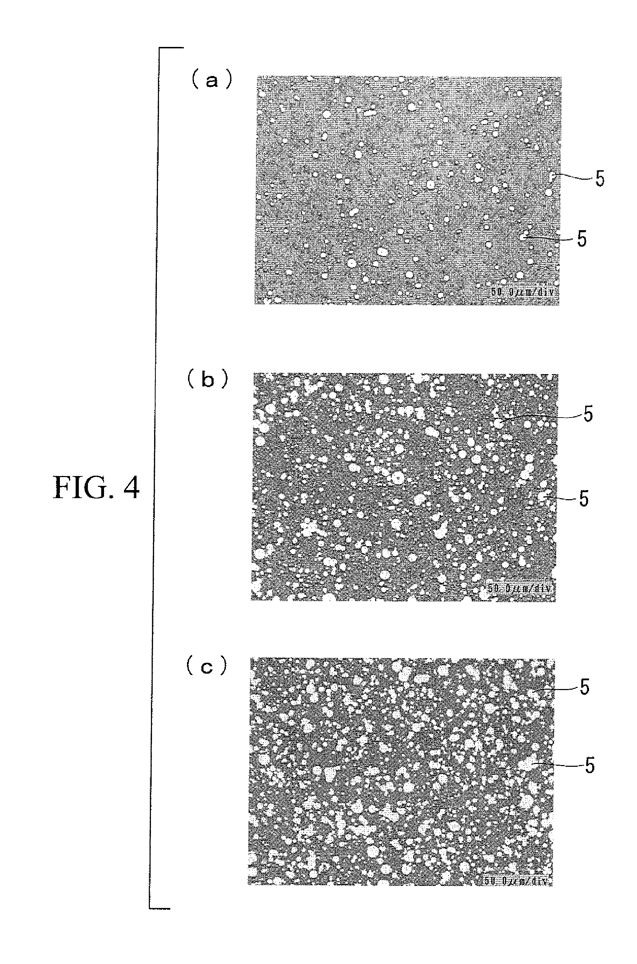

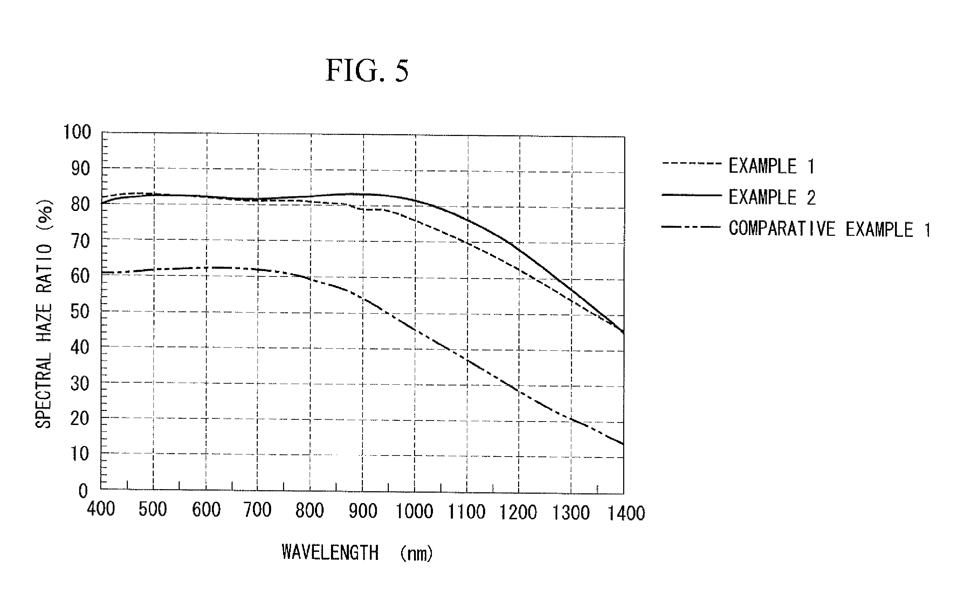

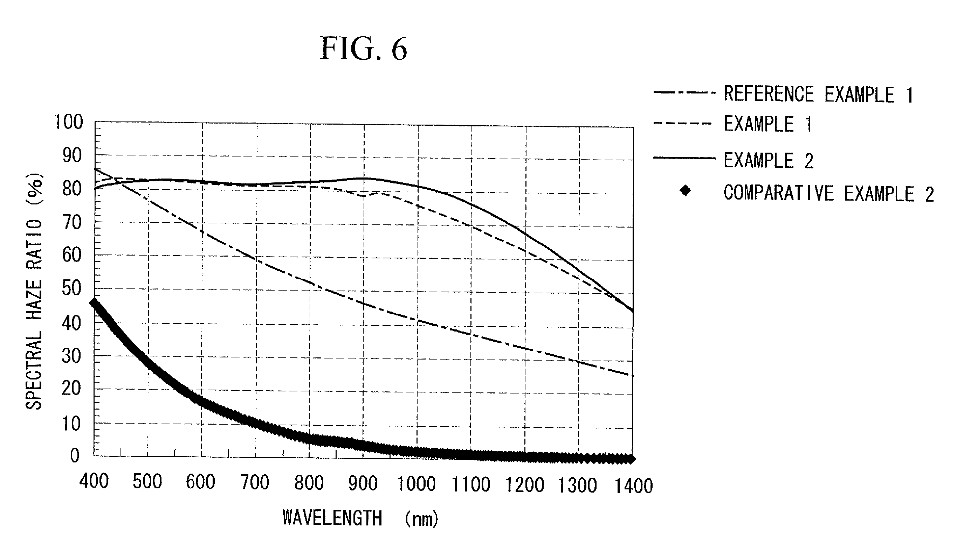

{Fig. 1} A schematic view illustrating the structure of a photovoltaic device produced using a process for producing a photovoltaic device according to the present invention.
{Fig. 2} A graph illustrating the temperature profile of a heat treatment within an embodiment of the present invention.
{Fig. 3} An electron microscope photograph of a transparent electrode layer of an example 2.
{Fig. 4} Optical microscope photographs of transparent electrode layers of (a) a reference example 1, (b) an example 1, and (c) the example 2.
{Fig. 5} A graph illustrating the spectral haze ratios of transparent electrode layers of the example 1, the example 2, and a comparative example 1.
{Fig. 6} A graph illustrating the spectral haze ratios of transparent electrode layers of the reference example 1, the example 1, the example 2, and a comparative example 2.

### {Description of Embodiments)

Fig. 1 is a schematic view illustrating the structure of a photovoltaic device according to the present invention. A photovoltaic device 100 is a triple-junction silicon-based solar cell, and comprises a substrate 1, a transparent electrode layer 2, a solar cell photovoltaic layer 3 comprising a first cell layer 91 (amorphous silicon-based), a second cell layer 92 (crystalline silicon-based) and a third cell layer 93 (crystalline silicon-based), and a back electrode layer 4. Here, the term "silicon-based" is a generic term that includes silicon (Si), silicon carbide (SiC) and silicon germanium (SiGe). Further, the term "crystalline silicon-based" describes a silicon system other than an amorphous silicon system, and includes both microcrystalline silicon systems and polycrystalline silicon systems.

A process for producing the photovoltaic device is described below as an embodiment according to the present invention.

A glass substrate having a flat surface (for example, #1737 glass manufactured by Corning Incorporated, dimensions: 50 mm × 50 mm × thickness: 1.1 mm) is used as the substrate 1.

A transparent conductive film having a thickness of approximately 2 µm and comprising mainly GZO (Ga-doped ZnO) is deposited on the glass substrate 1 as the transparent electrode layer 2, using a sputtering apparatus under reduced pressure conditions. The deposition is performed at room temperature. Although sputtering is used for deposition of the transparent electrode layer 2 in this embodiment, other methods such as MOCVD methods or thermal CVD methods may also be used. Furthermore, although GZO is used as the transparent electrode layer 2, AZO (Al-doped ZnO may also be used.

Following deposition, an etching treatment is performed to expose at least a portion of the substrate surface and form openings 5. Dilute hydrochloric acid is used as the etchant. The concentration and temperature of the etchant, and the treatment time may be adjusted as appropriate. The opening ratio of the transparent electrode layer 2 is preferably within a range from not less than 15% to not more than 25%. The thickness of the etched transparent electrode layer 2 is preferably 0.9 µm.
Subsequently, the transparent electrode layer 2 is subjected to a heat treatment. A graph illustrating the temperature profile for the heat treatment is shown in Fig. 2. The temperature is raised from room temperature to 560°C using ramp annealing under a high degree of vacuum (≤1.33×10⁻⁴ Pa), and following heat treatment for 15 minutes, the transparent electrode layer 2 is cooled by standing. The sheet resistance of the heat-treated transparent electrode layer 2 is preferably within a range from not less than 30 Ω/square to not more than 40 Ω/square.

Next, a titanium oxide film and a zinc oxide film are deposited sequentially as an antireflection layer that exhibits conductivity. In this case, the titanium oxide film is formed on the transparent electrode layer 2. The titanium oxide film comprises mainly titanium oxide, but may also include a dopant or the like to improve the conductivity. The thickness of the titanium oxide film is preferably within a range from not less than 10 nm to not more than 100 nm. The titanium oxide film is deposited using a sputtering method at a substrate temperature of approximately 300°C.
The zinc oxide film is formed on top of the titanium oxide film. The zinc oxide film comprises mainly zinc oxide, but may also include a dopant or the like to improve the conductivity. The thickness of the zinc oxide film is preferably within a range from not less than 1 nm to not more than 50 nm. In order to enable the zinc oxide film to be formed in a continuous manner following deposition of the titanium oxide film, the zinc oxide is preferably also deposited using a sputtering method.
By providing the antireflection layer in the manner described above, not only electrical loss, but also optical loss can be prevented.

Using a plasma-enhanced CVD apparatus, a p-layer, an i-layer and an n-layer, each composed of a thin film of amorphous silicon, are deposited as the first cell layer 91. Using SiH₄ gas and H₂ gas as the main raw materials, and under conditions including a reduced pressure atmosphere of not less than 30 Pa and not more than 1,000 Pa and a substrate temperature of not less than 180°C and not more than 200°C, an amorphous silicon p-layer 31, an amorphous silicon i-layer 32 and an amorphous silicon n-layer 33 are deposited, in that order, on the transparent electrode layer 2, with the p-layer closest to the surface from which incident sunlight enters. The amorphous silicon p-layer 31 comprises mainly amorphous B-doped silicon carbide, and has a thickness of not less than 10 nm and not more than 30 nm. The amorphous silicon i-layer 32 has a thickness of not less than 150 nm and not more than 350 nm. The amorphous silicon n-layer 33 comprises mainly P-doped silicon in which microcrystalline silicon is incorporated within amorphous silicon, and has a thickness of not less than 30 nm and not more than 60 nm. A buffer layer may be provided between the amorphous silicon p-layer 31 and the amorphous silicon i-layer 32 in order to improve the interface properties.

Subsequently, using a plasma-enhanced CVD apparatus, and under conditions including a reduced pressure atmosphere of not more than 3,000 Pa, a substrate temperature of not less than 140°C and not more than 200°C, and a plasma generation frequency of not less than 10 MHz and not more than 100 MHz, a crystalline silicon p-layer 41, a crystalline silicon i-layer 42 and a crystalline silicon n-layer 43 are deposited sequentially as the second cell layer 92 on top of the first cell layer 91. The crystalline silicon p-layer 41 comprises mainly B-doped microcrystalline silicon, and has a thickness of not less than 10 nm and not more than 50 nm. The crystalline silicon i-layer 42 comprises mainly microcrystalline silicon, and has a thickness of not less than 1.2 µm and not more than 3.0 µm. The crystalline silicon n-layer 43 comprises mainly P-doped microcrystalline silicon, and has a thickness of not less than 20 nm and not more than 60 nm.

Next, using a plasma-enhanced CVD apparatus, and under conditions including a reduced pressure atmosphere of not more than 3,000 Pa, a substrate temperature of approximately 200°C, and a plasma generation frequency of not less than 40 MHz and not more than 100 MHz, a crystalline silicon p-layer 61, a crystalline silicon germanium i-layer 62 and a crystalline silicon n-layer 63 are deposited sequentially as the third cell layer 93 on top of the second cell layer 92. The crystalline silicon p-layer 61 comprises mainly B-doped microcrystalline silicon, and has a thickness of not less than 10 nm and not more than 60 nm. The crystalline silicon germanium i-layer 62 comprises mainly microcrystalline silicon germanium, and has a thickness of not less than 2.0 µm and not more than 4.0 µm. The crystalline silicon n-layer 63 comprises amorphous silicon, crystalline silicon, or has a stacked structure formed from a combination of the two, wherein the thickness of the overall n-layer is not less than 20 nm and not more than 100 nm.

An intermediate contact layer that functions as a semi-reflective film for improving the contact properties and achieving electrical current consistency may be provided between the first cell layer 91 and the second cell layer 92, and between the second cell layer 92 and the third cell layer 93. In those cases where an intermediate contact layer is provided, a GZO (Ga-doped ZnO) film having a thickness of not less than 20 nm and not more than 100 nm may be deposited using a sputtering apparatus with a Ga-doped ZnO sintered body as the target.

Using a sputtering apparatus, an Ag film having a thickness of not less than 150 nm and not more than 500 nm is deposited as the back electrode layer 4, under a reduced pressure atmosphere and at room temperature. In order to reduce the contact resistance between the crystalline silicon n-layer 43 and the back electrode layer 4 and improve the light reflection, a sputtering apparatus may be used to deposit a backside transparent electrode layer, such as an AZO (Al-doped ZnO film) or a GZO (Ga-doped ZnO) film having a thickness of not less than 40 nm and not more than 100 nm, between the photovoltaic layer 3 and the back electrode layer 4.

Following deposition of the back electrode layer 4, post annealing is performed at a temperature of not less than 180°C and not more than 200°C for a period of 2 hours 10 minutes to complete the photovoltaic device. Appropriate cell separation is performed, and the power generation characteristics are evaluated. Examples of cell separation methods that may be employed include laser etching methods and RIE etching methods. The size of each cell is, for example, a surface area of 1 cm²

### {Examples}

### (Example 1, Example 2, and Reference Example 1)

A series of triple-junction solar cells having the structure illustrated in Fig. 1 were produced using a glass substrate 1 having a flat surface (#1737 glass manufactured by Corning Incorporated, dimensions: 50 mm × 50 mm × thickness: 1.1 mm). The solar cells of example 1, example 2 and reference example 1 were prepared using different etching conditions for the transparent electrode layer 2.
Transparent electrode layer 2: GZO film
Antireflection layer: TiO₂ film/AZO film, average thickness: 70 nm/10 nm
Amorphous silicon p-layer 31: average thickness: 20 nm
Amorphous silicon i-layer 32: average thickness: 180 nm
Amorphous silicon n-layer 33: average thickness: 60 nm
Crystalline silicon p-layer 41: average thickness: 15 nm
Crystalline silicon i-layer 42: average thickness: 2,000 nm
Crystalline silicon n-layer 43: average thickness: 60 nm
Crystalline silicon p-layer 61: average thickness: 60 nm
Crystalline silicon germanium i-layer 62: average thickness: 2,200 nm (compositional ratio Ge: 10%, Si: 90%)
Crystalline silicon n-layer 63: average thickness: 60 nm
Backside transparent electrode layer: AZO film, average thickness: 40 nm
Back electrode layer 4: Ag film, average thickness: 200 nm

The transparent electrode layer 2 was deposited by sputtering at room temperature, using Ar + 0.5% O₂ as a discharge gas and using a target material comprising ZnO doped with 5.7% by mass of Ga₂O₃, thus forming a layer having an average thickness of 2,000 nm. Subsequently, the transparent electrode layer 2 was subjected to an etching treatment by dipping for a predetermined time in a 0.6% by mass hydrochloric acid solution at room temperature, and the surface of the transparent electrode layer 2 was then washed thoroughly with pure water, and then dried.
Next, the transparent electrode layer 2 was subjected to a heat treatment. A graph illustrating the temperature profile for the heat treatment is shown in Fig. 2. In the figure, the horizontal axis represents the time and the vertical axis represents the glass substrate temperature. The temperature was raised from room temperature to 560°C by ramp annealing under a high degree of vacuum (≤1.33×10⁻⁴ Pa), and following heat treatment at that temperature for 15 minutes, the structure was left to cool by standing.

A titanium oxide film and a zinc oxide film were formed sequentially on the transparent electrode layer 2 as an antireflection layer that exhibits conductivity.
First, the substrate with the transparent electrode layer 2 formed thereon was mounted in a vacuum sputtering chamber, and the substrate was heated under vacuum to a temperature of approximately 300°C. Titanium oxide was then deposited on the transparent electrode layer 2 by sputtering. Subsequently, an Al-doped zinc oxide film was deposited on the titanium oxide film by sputtering, using ZnO doped with 2.0% by mass of Al₂O₃ as the target material.

### (Comparative Example 1)

The transparent electrode layer 2 was deposited by sputtering at room temperature, using Ar + 0.5% O₂ as a discharge gas and using a target material comprising ZnO doped with 5.7% by mass of Ga₂O3, thus forming a layer having an average thickness of 2,000 nm. Subsequently, the transparent electrode layer 2 was subjected to an etching treatment by dipping for a predetermined time in a 0.6% by mass hydrochloric acid solution at room temperature, and the surface of the transparent electrode layer 2 was then washed thoroughly with pure water, and then dried.
Next, heat treatment of the transparent electrode layer 2 was performed in the same manner as that described for reference example 1, example 1 and example 2. Comparative example 1, example 1 and example 2 differ only in terms of the etching treatment conditions, and the structure of the photovoltaic layer was the same in each case.

### (Comparative Example 2)

A transparent conductive film comprising mainly tin oxide (SnO₂) and having a thickness of approximately 1,000 nm was used (without etching) as the transparent electrode layer 2. The remaining structure was the same as the examples described above.

### (Thickness)

The thickness of the transparent electrode layer 2 following heat treatment was measured for reference example 1, example 1, example 2 and comparative example 1.
Details of the measurement method are described below. Using a commercially available laser microscope, the surface of the transparent electrode layer 2 was inspected. A line profile measurement was performed using the laser microscope, and the height distribution of the surface was determined. An analysis line including a through-hole region was selected, and the through-hole region was designated as the zero point, thus enabling correction of the zero level. Because spoon cuts exist within the transparent electrode layer 2, the apparent surface height distribution is uneven. The peaks of the uneven distribution were linked and selected as a measurement level, and the difference between the zero level and the measurement level was deemed the thickness of the layer. A spoon cut refers to a concave shape in the shape of a mortar.
For example, using a commercially available laser microscope VK8510 manufactured by Keyence Corporation, and selecting a 50× objective lens, line profiles can be measured at a height measurement pitch of 0.02 µm and a height measurement width of 4 µm.

The results of the above measurements are shown in Table 1. From Table 1 it is evident that altering the etching conditions (the etching time) resulted in a change in the thickness of the transparent electrode layer 2.

**{Table 1}**

| Sample | Etching conditions | Average thickness (µm) |
|---|---|---|
| Reference example 1 | Conditions 1 | 1.20 |
| Example 1 | Conditions 2 | 0.95 |
| Example 2 | Conditions 3 | 0.90 |
| Comparative example 1 | Conditions 4 | 0.70 |

### (Surface Observation)

For reference example 1, example 1 and example 2, the surface of the substrate 1 following formation of the antireflection layer was observed from a bird's-eye view using a commercially available electron microscope. The magnification was set to a value between approximately 2,000x and 50,000×, and the accelerating voltage was set to approximately 3 kV. Because a conductive coating is required as a pretreatment, the surface was coated with Pt.
For example, using a FESEM JSM-6301F apparatus from Jeol Ltd., an image can be captured at a tilt angle of 30° to 45°, an accelerating voltage of 3 kV, and a magnification of 2,000×.

Fig. 3 illustrates an electron microscope photograph of example 2 as a representative example. Fig. 3 confirmed the existence of a plurality of crater-shaped through-holes (openings 5) that reached through to the glass substrate.

### (Optical Microscope Observation and Calculation of Opening Ratio)

For reference example 1, example 1, example 2, comparative example 1 and comparative example 2, the surface of the substrate 1 following formation of the antireflection layer was observed by epi-illumination using a commercially available optical microscope. A magnification of approximately 1,000× is ideal. The observed image was recorded in black and white, and the intensity of the reflected light from the object was recorded on a gray scale.
Because the underlying flat surface is exposed within the through-hole regions, these regions have the strongest reflection intensity and the highest brightness level. In contrast, spoon cut regions scatter light, and therefore have the lowest brightness level. By setting a threshold at a brightness level determined by subtracting a predetermined value from the brightness level of the through-hole regions, the image can be converted to a binary image composed of through-holes and other regions. The ratio of the number of pixels that appear at the through-hole brightness level relative to the total number of pixels in the image was calculated and recorded as the opening ratio.
For example, using a commercially available digital optical microscope VH7000 manufactured by Keyence Corporation, the object may be observed at a magnification of 1,000×, with the image recorded using the black and white mode, and a painting software (AzPainter2) may then be used to set a threshold based on the method described above to convert the image to a binary image, before using an image analysis software (IrfanView) to determine the opening ratio by calculating the ratio described above.

Fig. 4(a) to Fig. 4(c) illustrate surface optical microscope photographs for reference example 1, example 1 and example 2 respectively. It is evident that as the etching time was increased from reference example 1 to example 1 and then to example 2, the proportion of depressions within the uneven surface that reached the substrate (namely, through-holes) increased. The opening ratios in reference example 1, example 1 and example 2 were 4%, 16% and 22% respectively. Further, the opening ratios in comparative example 1 and comparative example 2 were 28% and 0% respectively.

### (Spectral Haze Ratio)

For reference example 1, example 1, example 2, comparative example 1 and comparative example 2, the spectral haze ratio of the sample following heat treatment was measured using a commercially available spectrophotometer fitted with an integrating sphere.
Details of the measurement method are described below. The substrate 1 having the transparent electrode layer 2 formed thereon was positioned in the light transmittance measurement position so that the incident light was irradiated onto the non-deposited surface of the substrate 1 (namely, the surface opposite the transparent electrode layer 2), and a normal transmittance measurement was performed. The result obtained from this measurement represents the total transmittance spectrum T (vertical transmittance + diffuse transmittance). Next, the white plate installed in a position in the integrating sphere opposing the test piece was removed, and using an optical configuration in which the vertically transmitted light was discharged from the integrating sphere, a second transmittance measurement was performed. The result of this measurement represents the diffuse transmittance spectrum Td. The spectral haze ratio Hz(λ) was then calculated from the formula: MHz (λ) = Td(λ)/T(λ).
For example, the above measurements can be performed by fitting a Ø60 integrating sphere to a commercially available spectrophotometer U-3500 manufactured by Hitachi, Ltd.

The results of the above measurements are illustrated in Fig. 5 and Fig. 6. Fig. 5 shows the spectral haze ratios for the transparent electrode layers 2 of example 1, example 2 and comparative example 1.
Compared with comparative example 1, example 1 and example 2 have a substantially higher haze ratio at all wavelengths. In particular, in the long wavelength region of wavelengths from 800 nm to 1,100 nm, a haze ratio of approximately 65% was able to be maintained. This result confirmed that the haze ratio could be increased by ensuring that the thickness of the transparent electrode layer 2 was not less than a predetermined value. In other words, if the thickness of the residual transparent electrode layer 2 following etching is too thin, then a high haze ratio cannot be achieved across the broad range of light wavelengths used by the solar cell. Accordingly, by appropriate adjustment of the etching conditions, including the etching time, the etchant concentration and temperature, and the use of stirring, thereby ensuring an average thickness not less than a predetermined value, a high haze ratio can be obtained across the broad range of light wavelengths used by the solar cell.

Fig. 6 shows the spectral haze ratios for the transparent electrode layers 2 of reference example 1, example 1, example 2 and comparative example 2. Because the opening ratio of reference example 1 was lower than that of example 1 and example 2, the light-scattering effect caused by the asperity on the surface of the transparent electrode layer 2 was relatively less, resulting in a lower haze ratio than example 1 and example 2 at almost all wavelength values excluding the short wavelength region. In other words, a higher opening ratio enables a higher haze ratio to be obtained across a broad wavelength region.

Further, reference example 1, example 1 and example 2 all exhibited higher haze ratios than comparative example 2 for all wavelength regions. Comparative example 2 had no openings 5 and was subjected to no etching treatment. As a result, it is thought that the surface of the transparent electrode layer 2 had a smaller pitch, lower height, and inferior surface scattering characteristics, resulting in a lower haze ratio.

### (Sheet Resistance)

For reference example 1, example 1 and example 2, the sheet resistance of the sample following heat treatment was measured using a four-probe resistance measurement apparatus "Loresta IP" MCP-T250 (manufactured by Mitsubishi Chemical Corporation).
The sheet resistance values for reference example 1, example 1 and example 2 were 13 Ω/square, 33 Ω/square and 35 Ω/square respectively.
The sheet resistance of comparative example 2 was 8 Ω/square.

### (Electric Power Generation Characteristics)

For the triple-junction solar cells of reference example 1, example 1, example 2 and comparative example 2, the current-voltage characteristics per 1 cm² of surface area were measured under AM 1.5 (100 mW/cm²) illumination conditions.

### (Spectral Sensitivity Characteristics)

The spectral sensitivity characteristics of the triple-junction solar cells of reference example 1, example 1, example 2 and comparative example 2 were measured under conditions including white bias light illumination, room temperature, a bias voltage of 0 V, and a light-receiving area of 1 cm².
Because the current value within a multi-junction solar cell is limited by the smallest value among the photocurrents generated by each of the photovoltaic layers, the spectral sensitivity at a specific wavelength refers to the value for the photovoltaic layer having the lowest sensitivity relative to that particular wavelength. Accordingly, the spectral sensitivity characteristics for the first cell layer 91, the second cell layer 92 and the third cell layer 93 were measured by adding a filter for measuring each photovoltaic layer to the bias light, thereby increasing the current value for the other cells not being measured, and creating current-limiting conditions for the cell being measured.

The results of the above tests are shown in Table 2. The numerical values are reported as relative values in relation to comparative example 2.

**{Table 2}**

| Sample | η | Voc | F.F. | Jsc | Spectral Jsc | | | |
|---|---|---|---|---|---|---|---|---|
| | | | | | First cell layer | Second cell layer | Third cell layer | Total |
| Reference example 1 | 1.05 | 1.02 | 1.00 | 1.04 | 0.97 | 1.05 | 1.04 | 1.01 |
| Example 1 | 1.07 | 1.03 | 1.01 | 1.02 | 0.96 | 0.99 | 1.17 | 1.03 |
| Example 2 | 1.13 | 1.03 | 1.00 | 1.10 | 0.97 | 1.09 | 1.10 | 1.05 |
| Comparative example 2 | 1.00 | 1.00 | 1.00 | 1.00 | 1.00 | 1.00 | 1.00 | 1.00 |

The short-circuit current values (Jsc) for reference example 1, example 1 and example 2 were all higher than that of comparative example 2. It is thought that these results are due to an increase in the haze ratio of the long wavelength region and an improvement in the light containment effect achieved as a result of the etching treatment.

The open-circuit voltage values (Voc) for reference example 1, example 1 and example 2 were all higher than that of comparative example 2. Further, there was a tendency for the open-circuit voltage to increase with increasing opening ratio. It is thought that these results are due to increased flat regions produced by the existence of a plurality of openings 5. These results confirmed that a high open-circuit voltage could be achieved when the opening ratio was not less than 15% and not more than 25%.

The fill factor values (F.F.) for reference example 1, example 1 and example 2 substantially retained the high value of comparative example 2.

The short-circuit current in the second cell layer 92 and the third cell layer 93 of reference example 1, example 1 and example 2 increased compared with the equivalent layers in comparative example 2, and the total current obtained from the photovoltaic layer 3 also increased. In other words, for the triple-junction solar cell having a a-Si/µc-Si/µc-SiGe structure, reference example 1, example 1 and example 2 all yield a higher electric current than the conventionally used comparative example 2.
In example 1 and example 2, lengthening the etching time of the transparent electrode layer 2 compared with reference example 1 increased the haze ratio for the long wavelength region, and also increased the current value obtained for the third cell layer 93. As a result, the total current value also increased. In example 2, because the etching treatment conditions were adjusted (improved) so that the haze ratio for the long wavelength region comprising wavelengths from 800 nm to 1,100 nm was increased to approximately 65% (by extending the shoulder towards longer wavelengths), the current value obtained for the second cell layer 92 was increased. As a result, the short-circuit current values obtained for each of the photovoltaic layers was able to be better equalized, resulting in a further increase in the total electric current value.

On the basis of the above results it was evident that increasing the haze ratio across the entire wavelength region enabled a higher total electric current to be obtained for a triple-junction solar cell. The haze ratio for the long wavelength region (from 800 nm to 1,100 nm) is preferably 65% or greater.

### {Reference Signs List}

- 1: Substrate
- 2: Transparent electrode layer
- 3: Photovoltaic layer
- 4: Back electrode layer
- 5: Opening
- 6: Solar cell module
- 31: Amorphous silicon p-layer
- 32: Amorphous silicon i-layer
- 33: Amorphous silicon n-layer
- 41: Crystalline silicon p-layer
- 42: Crystalline silicon i-layer
- 43: Crystalline silicon n-layer
- 61: Crystalline silicon p-layer
- 62: Crystalline silicon germanium i-layer
- 63: Crystalline silicon n-layer
- 91: First cell layer
- 92: Second cell layer
- 93: Third cell layer
- 100: Photovoltaic device

## Claims

1. A thin-film photovoltaic device, comprising:
a transparent electrode layer and three silicon-based photovoltaic layers stacked in sequence on a substrate,
wherein
the transparent electrode layer has at least one opening formed by an etching treatment that exposes a surface of the substrate, and
a haze ratio of the transparent electrode layer relative to light of a broad wavelength region is at least 60%.

2. The thin-film photovoltaic device according to claim 1, wherein a haze ratio of the transparent electrode layer relative to light having a wavelength from 800 nm to 1,100 nm is 65% or greater.

3. The thin-film photovoltaic device according to claim 1 or claim 2, wherein an opening ratio within the transparent electrode layer is not less than 15% and not more than 25%.

4. The thin-film photovoltaic device according to any one of claims 1 to 3, wherein a sheet resistance of the transparent electrode layer is not less than 30 Ω/square and not more than 40 Ω/square.

5. The thin-film photovoltaic device according to any one of claims 1 to 4, wherein a thickness of the transparent electrode layer is not less than 0.9 µm.

6. The thin-film photovoltaic device according to any one of claims 1 to 5, wherein an antireflection layer that exhibits conductivity is formed on the transparent electrode layer.
